# EUROPÄISCHE PATENTSCHRIFT

(11) **EP 4 743 793 B1**
(45) Veröffentlichungstag und Bekanntmachung des Hinweises auf die Patenterteilung: **09.12.2026**
(21) Anmeldenummer: 25709260.1
(22) Anmeldetag: 19.02.2025
(51) Int. Cl.: G01R 31/34, G01R 35/00, H02M 1/00

(54) **BATTERIESIMULATOR, TESTAUFBAU, VERFAHREN ZUM BETREIBEN EINES BATTERIESIMULATORS SOWIE VERFAHREN ZUM TESTEN EINES PRÜFLINGS**
BATTERY SIMULATOR, TEST SETUP, METHOD FOR OPERATING A BATTERY SIMULATOR AND METHOD FOR TESTING A TEST OBJECT
SIMULATEUR DE BATTERIE, MONTAGE DE TEST, PROCÉDÉ DE FONCTIONNEMENT D'UN SIMULATEUR DE BATTERIE ET PROCÉDÉ DE TEST D'UN OBJET DE TEST

(30) Priorität: 19.02.2024 AT 501342024
(43) Veröffentlichungstag der Anmeldung: 20.05.2026
(73) Patentinhaber: KRISTL, SEIBT & CO. GESELLSCHAFT M.B.H., 8052 Graz (AT)
(72) Erfinder: VORAUER, Manfred, 8511 Stainz (AT)
(74) Vertreter: SONN Patentanwälte GmbH & Co KG
(86) Internationale Anmeldenummer: PCT/AT2025/060064
(87) Internationale Veröffentlichungsnummer: WO 2025/175329

(56) Entgegenhaltungen:
- WO-A1-2013/174967
- WO-A1-2018/108779
- CN-A- 102 183 984
- KR-B1- 102 607 413

## Beschreibung

Die Erfindung betrifft einen Batteriesimulator zum Testen eines Prüflings, insbesondere einer elektrischen Antriebseinheit für ein Fahrzeug, aufweisend:
eine erste Spannungsabwärtswandlereinheit mit
   - zumindest einem ersten Schalter,
   - einem ersten Zwischenkreis,
   - einem ersten Ausgang und
   - einem ersten Spannungsbezugspunkt,
wobei die erste Spannungsabwärtswandlereinheit dazu eingerichtet ist, den zumindest einen ersten Schalter gemäß zumindest eines ersten Schaltmusters zu schalten und dadurch eine erste Zwischenkreisspannung des ersten Zwischenkreises in eine erste Ausgangsspannung zu wandeln, welche im Betrieb des Batteriesimulators zwischen dem ersten Spannungsbezugspunkt und dem ersten Ausgang anliegt.

Des Weiteren betrifft die Erfindung ein Verfahren zum Betreiben eines Batteriesimulators, einen Testaufbau sowie ein Verfahren zum Testen eines Prüflings.

Die Spannung an einem realen elektrischen Energiespeicher, wie zum Beispiel einer Batterie oder einem Akkumulator, ist nicht konstant, sondern hängt vom Verlauf des aktuellen und des vergangenen Stromflusses, von der abgerufenen elektrischen Leistung, vom Ladezustand, von der Temperatur, von der Alterung des Energiespeichers und von vielen weiteren Dingen ab. Möchte man einen batterie- oder akkubetriebenen Prüfling, zum Beispiel eine elektrische Antriebseinheit eines Fahrzeugs, an einem Prüfstand realistisch betreiben, könnte man eine reale Batterie verwenden. Der Zeitaufwand, um die Batterie vor jedem Prüflauf in den gewünschten Zustand (Ladezustand, Temperatur, Alterung usw.) zu versetzen, wäre allerdings enorm und nicht immer zuverlässig reproduzierbar. Deswegen werden an einem Prüfstand üblicherweise sogenannte Batteriesimulatoren bzw. Batterieemulatoren eingesetzt. Ein Batteriesimulator stellt grob gesprochen im Wesentlichen eine steuerbare Spannungsquelle dar, die eine von einem Simulationsmodell berechnete oder vorgegebene Batteriesimulatorausgangsspannung ausgibt und dem Prüfling während des Prüflaufs zur Verfügung stellt.

Um eine gewünschte Batteriesimulatorausgangsspannung zu erzeugen, ist aus dem Stand der Technik bekannt, einstellbare Spannungsabwärtswandlereinheiten zu verwenden, die es ermöglichen, eine elektrische Zwischenkreisspannung auf ein vorgegebenes niedrigeres Spannungsniveau zu wandeln und dadurch eine Batteriesimulatorausgangsspannung zur Verfügung zu stellen, die zwischen 0 V und der Zwischenkreisspannung liegt. Beispielsweise offenbart die WO 2013/174967 A1 einen Batteriesimulator mit einer Ausgangsstufe, die drei versetzt schaltende Step-down-DC-DC-Wandler mit einem gemeinsamen Ausgangskondensator aufweist. Auch die AT 520392 A1 offenbart einen Batteriesimulator mit einem solchen Aufbau.

Moderne Batteriesimulatoren können Batteriesimulatorausgangsspannungen von bis zu 1000 V mit einer Leistung von bis zu 1 MW liefern. Aktuelle Entwicklungen bei elektrisch betriebenen Fahrzeugen gehen jedoch in Richtung noch höherer Spannungen, sodass auch bei Batteriesimulatoren höhere Batteriesimulatorausgangsspannungen gefragt werden. Allerdings kann zur Erzeugung höherer Batteriesimulatorausgangsspannungen nicht einfach die Zwischenkreisspannung einer Spannungsabwärtswandlereinheit beliebig erhöht werden, da dadurch die für die korrekte und sichere Funktionsweise der Spannungsabwärtswandlereinheit maximale Betriebsspannung der eingesetzten elektrischen Schalter überschritten werden könnte. Die maximale Betriebsspannung vieler für Batteriesimulatoren geeigneter Schalter liegt bei ca. 1000 V und damit, um die Betriebssicherheit zu gewährleisten, insbesondere deutlich unterhalb der Sperrspannung der Schalter. Des Weiteren verlangt die sogenannte Niederspannungsrichtlinie 2014/35/EU vom 26. Februar 2014 eine maximale Potentialdifferenz von 1500 V bei Gleichspannungs- bzw. Gleichstromanwendungen. Auch dadurch sind die Möglichkeiten, Spannungserhöhungen und Änderungen im Schaltungsdesign von Batteriesimulatoren vorzunehmen, erheblich eingeschränkt.

Batteriesimulatoren mit Spannungswandlereinheiten sind unter anderem aus KR 102607413 B1 und CN 102183984 A bekannt. Die Spannungswandlereinheiten sind in Serie geschaltet, um höhere Spannungen zu erzielen. Die WO 2013/174967 A1 betrifft ein Verfahren zum Testen eines Antriebsstranges, wobei ein Simulationssystem für ein Energiespeichersystem verwendet wird.

Eine Vorrichtung zur Erzeugung einer geschalteten elektrischen Gleichspannung mit einem Transformator, einem Gleichrichtermodul und einem Gleichspannungswandlermodul ist zudem aus WO 2018/108779 A1 bekannt.

Im Lichte dieser Ausführungen ist es Aufgabe der vorliegenden Erfindung, die Nachteile des Standes der Technik zu lindern oder gänzlich zu beseitigen. Vorzugsweise ist es Aufgabe der vorliegenden Erfindung, die Batteriesimulatorausgangsspannung eines Batteriesimulators der eingangs erwähnten Art unter Einhaltung der Niederspannungsrichtlinie auf insbesondere bis zu 1500 V zu erhöhen.

Gelöst wird diese Aufgabe durch einen Batteriesimulator gemäß Anspruch 1, einen Testaufbau gemäß Anspruch 13, ein Verfahren zum Betreiben eines Batteriesimulators gemäß Anspruch 14 und ein Verfahren zum Testen eines Prüflings gemäß Anspruch 15.

Erfindungsgemäß ist bei einem Batteriesimulator der eingangs erwähnten Art eine zweite Spannungsabwärtswandlereinheit mit
- zumindest einem zweiten Schalter,
- einem zweiten Zwischenkreis,
- einem zweiten Ausgang und
- einem zweiten Spannungsbezugspunkt

vorgesehen, wobei die zweite Spannungsabwärtswandlereinheit dazu eingerichtet ist, den zumindest einen zweiten Schalter gemäß zumindest eines zweiten Schaltmusters zu schalten und dadurch eine zweite Zwischenkreisspannung des zweiten Zwischenkreises in eine zweite Ausgangsspannung zu wandeln, welche im Betrieb des Batteriesimulators zwischen dem zweiten Spannungsbezugspunkt und dem zweiten Ausgang anliegt,
wobei der erste Ausgang und der zweite Ausgang elektrisch miteinander verbunden sind und ein elektrischer Batteriesimulatorausgang mit dem ersten und dem zweiten Spannungsbezugspunkt verbunden ist, sodass im Betrieb des Batteriesimulators eine Batteriesimulatorausgangsspannung zwischen dem ersten und dem zweiten Spannungsbezugspunkt anliegt und an dem Batteriesimulatorausgang abgreifbar ist. Vorteilhafterweise kann durch diese Art der Verschaltung die Batteriesimulatorausgangsspannung im Vergleich zum Stand der Technik erhöht werden, ohne die erste Zwischenkreisspannung in entsprechendem Maße zu erhöhen und ohne Potentialdifferenzen innerhalb des Batteriesimulators zu erzeugen, die bei einer Batteriesimulatorausgangsspannung von 1500 V die Anwendung der Niederspannungsrichtlinie ausschließen würden. Bei bekannten seriellen Verschaltungen von Spannungsabwärtswandlereinheiten, bei denen der Pluspol des Zwischenkreises einer Spannungsabwärtswandlereinheit mit dem Minuspol des Zwischenkreises einer anderen Spannungsabwärtswandlereinheit verbunden wird, kann zwar ebenfalls die Batteriesimulatorausgangsspannung erhöht werden. Allerdings entstehen dadurch bei entsprechend hohen Zwischenkreisspannungen Potentialdifferenzen innerhalb des Batteriesimulators, die die Anwendung der Niederspannungsrichtlinie ausschließen würden. Mit dem erfindungsgemäßen Batteriesimulator kann die Anwendung der Niederspannungsrichtlinie gewährleistet bleiben und die Überschreitung der maximalen Betriebsspannungen von Schaltern vermieden werden. Der erfindungsgemäße Batteriesimulator kann dazu eingerichtet sein, eine Batterie oder einen Akkumulator in einem vorgegebenen Betriebszustand zu simulieren. Zu diesem Zweck kann die Batteriesimulatorausgangsspannung vorzugsweise stufenlos zwischen einer maximalen Batteriesimulatorausgangsspannung und 0 V einstellbar sein. Die maximal einstellbare Batteriesimulatorausgangsspannung kann beispielsweise zumindest 1200 V, zumindest 1400 V oder 1500 V betragen. Somit ist die Batteriesimulatorausgangsspannung zwischen 0 V und beispielsweise zumindest 1200 V, zumindest 1400 V oder 1500 V einstellbar. Die Batteriesimulatorausgangsspannung kann bei einer Ausführungsform der Erfindung von einem Simulationsmodell vorgegeben werden. Bei dem Prüfling kann es sich insbesondere um eine elektrischen Antriebseinheit für ein Fahrzeug, insbesondere ein elektrisch angetriebenes Fahrzeug, handeln. Eine solche elektrische Antriebseinheit kann beispielsweise eine elektrische Maschine und vorzugsweise einen Wechselrichter aufweisen. Die erste und die zweite Spannungsabwärtswandlereinheit können jeweils gleichartig ausgebildet sein und die gleichen elektrischen Komponenten besitzen. "Gleichartig ausgebildet" bezieht sich auf die Funktionsweise der Spannungsabwärtswandlereinheiten und schließt nicht aus, dass diese unabhängig voneinander betrieben werden und beispielsweise gespiegelt zueinander angeordnet sind. Vorzugsweise weisen die erste und die zweite Spannungsabwärtswandlereinheit jeweils zumindest eine Tiefsetzstellereinheit auf. Bei dem zumindest einen ersten und/oder dem zumindest einen zweiten Schalter kann es sich um einen Leistungsschalter, beispielsweise um einen IGBT-Schalter (IGBT = Insulated-Gate Bipolar Transistor) oder um einen MOSFET-Schalter (MOSFET = Metal Oxide Semiconductor Field-Effect Transistors), insbesondere um einen SiC-MOSFET-Schalter (SiC = Silicon Carbide), handeln. Der erste und/oder der zweite Zwischenkreis kann als Gleichspannungszwischenkreis ausgebildet sein. Im Betrieb des Batteriesimulators liegt am ersten Ausgang die erste Ausgangsspannung an, welche durch Einstellen des ersten Schaltmusters, insbesondere des ersten Tastverhältnisses des ersten Schaltmusters, hinsichtlich ihrer Höhe zwischen der ersten Zwischenkreisspannung und 0 V liegt. Analog liegt im Betrieb des Batteriesimulators am zweiten Ausgang die zweite Ausgangsspannung an, welche durch Einstellen des zweiten Schaltmusters, insbesondere des zweiten Tastverhältnisses des zweiten Schaltmusters, hinsichtlich ihrer Höhe zwischen der zweiten Zwischenkreisspannung und 0 V liegt. Der erste Ausgang und der erste Spannungsbezugspunkt sind innerhalb des Batteriesimulators örtlich voneinander getrennt und insbesondere nicht zueinander kurzgeschlossen. Auch der zweite Ausgang und der zweite Spannungsbezugspunkt sind innerhalb des Batteriesimulators örtlich voneinander getrennt und insbesondere nicht zueinander kurzgeschlossen. Die erste Ausgangsspannung und die zweite Ausgangsspannung können, aber müssen nicht gesondert von außen abgreifbar sein. Das erste und das zweite Schaltmuster, insbesondere das jeweilige erste bzw. zweite Tastverhältnis, können vorzugsweise unabhängig voneinander eingestellt werden, sodass die erste und die zweite Ausgangsspannung unterschiedlich sein können. Das erste und/oder das zweite Schaltmuster kann beispielsweise ein PWM-Schaltmuster sein. Das erste und/oder das zweite Schaltmuster wird vorzugsweise durch zumindest eine Steuer- und/oder Regelungseinrichtung des Batteriesimulators eingestellt und erzeugt. Mithilfe der zumindest einen Steuer- und/oder Regelungseinrichtung können die erste Ausgangsspannung, die zweite Ausgangsspannung und/oder die Batteriesimulatorausgangsspannung gesteuert und/oder geregelt werden. Zu diesem Zweck können jeweils an dem ersten Ausgang, an dem zweiten Ausgang und/oder an dem Batteriesimulatorausgang Spannungsmesssensoren vorgesehen sein. Die erste und die zweite Spannungsabwärtswandlereinheit sind bevorzugt mit Ausnahme der elektrischen Verbindung des ersten und des zweiten Ausgangs galvanisch voneinander getrennt. Die Verbindung des ersten und des zweiten Ausgangs kann mittels einer elektrischen Verbindungsleitung erfolgen. Bevorzugt ist, wenn der erste und der zweite Ausgang direkt, d.h. nicht über ein elektrisches Bauelement wie ein elektrischer Widerstand, verbunden sind. Mit anderen Worten sind der ersten und der zweite Ausgang vorzugsweise miteinander kurzgeschlossen. Im Betrieb des Batteriesimulators beträgt die erste und/oder die zweite Zwischenkreisspannung bevorzugt zwischen 400 V und 1000 V, besonders bevorzugt zwischen 600 V und 900 V, insbesondere im Wesentlichen 800 V. Im Betrieb des Batteriesimulators ist die Batteriesimulatorausgangsspannung zwischen 0 V und vorzugweise zumindest 1000 V, zumindest 1200 V, zumindest 1400 V oder zumindest 1500 V einstellbar. Der erste und der zweite Spannungsbezugspunkt können direkt oder indirekt, beispielsweise über ein elektrisches Bauelement, mit dem Batteriesimulatorausgang, insbesondere mit Klemmen des Batteriesimulatorausgangs, verbunden sein. Der Batteriesimulatorausgang ist vorzugsweise zweipolig. Der Batteriesimulatorausgang kann bei einer besonders bevorzugten Ausführungsform der Erfindung durch den ersten und den zweiten Spannungsbezugspunkt selbst gebildet sein. Dabei wird ein Pol des Batteriesimulatorausgangs durch den ersten Spannungsbezugspunkt und der andere Pol des Batteriesimulatorausgangs durch den zweiten Spannungsbezugspunkt gebildet. Der Batteriesimulator kann ein Gehäuse aufweisen. Der Batteriesimulatorausgang kann in das Gehäuse integriert sein oder an dem Gehäuse angeordnet sein. Die erste und die zweite Spannungsabwärtswandlereinheit können innerhalb des Gehäuses angeordnet sein.

Die erste und der zweite Spannungsabwärtswandlereinheit können jeweils einen Pluspol und einen Minuspol aufweisen, die vorzugsweise mit dem Pluspol und Minuspol des ersten bzw. zweiten Zwischenkreises zusammenfallen. Bei einer bevorzugten Ausführungsform der Erfindung ist vorgesehen, dass der erste Spannungsbezugspunkt mit einem Pluspol der ersten Spannungsabwärtswandlereinheit verbunden ist und vorzugsweise im Wesentlichen ein Pluspotential des ersten Zwischenkreises besitzt, und/oder der zweite Spannungsbezugspunkt mit einem Minuspol der zweiten Spannungsabwärtswandlereinheit verbunden ist und vorzugsweise im Wesentlichen ein Minuspotential des zweiten Zwischenkreises besitzt. Somit können durch Einstellen des ersten Schaltmusters eine erste Ausgangsspannung, die zwischen dem ersten Ausgang und dem Pluspol der ersten Spannungsabwärtswandlereinheit liegt, und eine zweite Ausgangsspannung, die zwischen dem zweiten Ausgang und dem Minuspol der ersten Spannungsabwärtswandlereinheit liegt, erzeugt werden. Der erste Spannungsbezugspunkt kann direkt oder indirekt, beispielsweise über ein elektrisches Bauelement, mit dem Pluspol der ersten Spannungsabwärtswandlereinheit verbunden sein. Der zweite Spannungsbezugspunkt kann direkt oder indirekt, beispielsweise über ein elektrisches Bauelement, mit dem Minuspol der zweiten Spannungsabwärtswandlereinheit verbunden sein.

Bevorzugt ist, wenn die erste und die zweite Spannungsabwärtswandlereinheit ausschließlich über den ersten und den zweiten Ausgang elektrisch miteinander verbunden sind. Die erste und die zweite Spannungsabwärtswandlereinheit können über weiter unten noch näher zu beschreibende Netzumrichter und zumindest einen Transformator mit einem Energieversorgungsnetz verbunden sein. Die Netzumrichter sind jedoch vorzugsweise galvanisch voneinander getrennt, sodass in dieser Hinsicht keine elektrische Verbindung, sondern allenfalls eine indirekte magnetische Kopplung vorliegt.

Vorzugsweise sind die erste und die zweite Spannungsabwärtswandlereinheit im Wesentlichen ident ausgebildet. Ident ausgebildet bedeutet in diesem Zusammenhang, dass die erste und die zweite Spannungsabwärtswandlereinheit strukturell und funktionell ident aufgebaut sind. Die Spannungsabwärtswandlereinheit können jedoch zueinander gespiegelt oder gedreht vorliegen und im Betrieb des Batteriesimulators unterschiedliche Ausgangsspannungsniveaus ausgeben.

Um die erste und die zweite Spannungsabwärtswandlereinheit mit elektrischer Energie zu versorgen, ist es günstig, wenn der Batteriesimulator einen ersten Netzumrichter und einen zweiten Netzumrichter aufweist, wobei der erste Netzumrichter mit dem ersten Zwischenkreis und der zweite Netzumrichter mit dem zweiten Zwischenkreis verbunden ist. Der erste und/oder der zweite Netzumrichter kann insbesondere als Gleichrichter ausgebildet sein und eine Wechselspannung eines Energieversorgungsnetzes in eine Gleichspannung für den ersten bzw. zweiten Zwischenkreis wandeln. Der erste und/oder der zweite Netzumrichter kann bei einer Ausführungsform einen dreiphasigen Eingang für eine dreiphasige Wechselspannung aufweisen. Wenn der erste und/oder der zweite Netzumrichter als Gleichrichter ausgebildet ist, kann dieser einen Gleichspannungsausgang aufweisen, der mit dem ersten bzw. zweiten Zwischenkreis verbunden werden kann.

Bevorzugt ist, wenn der erste Netzumrichter und der zweite Netzumrichter galvanisch voneinander getrennt sind.

Um den ersten und den zweiten Netzumrichter galvanisch voneinander zu trennen, kann vorgesehen sein, dass der Batteriesimulator zumindest einen Transformator aufweist, der dazu eingerichtet ist, den ersten und/oder den zweiten Netzumrichter zu speisen. Bei einer Ausführungsform der Erfindung kann ein erster Transformator für den ersten Netzumrichter und ein zweiter Transformator für den zweiten Netzumrichter eingesetzt werden. Möglich ist aber auch, einen gemeinsamen Trenntransformator mit zumindest zwei Abgängen, die vorzugweise jeweils drei Außenleiterausgänge aufweisen, zu verwenden. Der erste Netzumrichter kann mit dem ersten Abgang und der zweite Netzumrichter mit dem zweiten Abgang des Trenntransformators verbunden sein.

Bei einer Ausführungsform der Erfindung kann die erste Spannungsabwärtswandlereinheit zumindest eine erste Tiefsetzstellereinheit aufweisen, welche zumindest einen ersten Schalter und ein erstes Induktivitätsbauelement aufweist. Durch den zumindest einen ersten Schalter und das zumindest eine erste Schaltmuster kann das erste Induktivitätsbauelement derart mit elektrischer Energie geladen und entladen werden, dass die erste Ausgangsspannung gegenüber der ersten Zwischenkreisspannung herabgesetzt wird. Die Funktionsweise von Tiefsetzstellereinheiten mit zumindest einem Schalter und einem Induktivitätsbauelement ist aus dem Stand der Technik hinlänglich bekannt, sodass hier nicht näher darauf eingegangen wird.

Auch die zweite Spannungsabwärtswandlereinheit kann zumindest eine zweite Tiefsetzstellereinheit aufweisen, welche zumindest einen zweiten Schalter und ein zweites Induktivitätsbauelement aufweist. Die im Zusammenhang mit der ersten Tiefsetzstellereinheit beschriebenen Merkmale, Effekte und Funktionsweisen gelten entsprechend auch für die zweite Tiefsetzstellereinheit.

Viele Tiefsetzstellereinheiten aus dem Stand der Technik verwenden eine Diode, die bei geschlossenem Schalter den Strompfad durch die Diode sperrt, bei geöffnetem Schalter aber einen Stromfluss ermöglicht. Dies erlaubt jedoch keine Rückspeisung von elektrischer Energie. Um die Rückspeisung von elektrischer Energie in das Energieversorgungsnetz zu ermöglichen, ist bei einer Ausführungsform der Erfindung vorgesehen, dass die zumindest eine erste Tiefsetzstellereinheit zwei erste Schalter aufweist, die über eine erste Verbindungsleitung elektrisch verbunden sind, wobei das erste Induktivitätsbauelement mit der ersten Verbindungsleitung und dem ersten Ausgang elektrisch verbunden ist und die erste Spannungsabwärtswandlereinheit vorzugsweise dazu eingerichtet ist, die zwei ersten Schalter der ersten Tiefsetzstellereinheit gegensinnig zueinander zu schalten. Die Zusammenschaltung der beiden ersten Schalter kann auch als Halbbrücke bezeichnet werden. Um die zwei ersten Schalter gegensinnig zu schalten, können beispielsweise zueinander jeweils invertierte erste Schaltmuster für die beiden ersten Schalter verwendet werden oder einer der ersten Schalter als Öffner und der andere der ersten Schalter als Schließer ausgebildet sein, sodass ein gemeinsames erstes Schaltmuster für beide erste Schalter verwendet werden kann. Gegensinnig bedeutet somit, dass der eine erste Schalter stets aktiviert ist, während der andere erste Schalter deaktiviert ist.

Auch hinsichtlich der zweiten Spannungsabwärtswandlereinheit kann vorgesehen sein, dass die zumindest eine zweite Tiefsetzstellereinheit zwei zweite Schalter aufweist, die über eine zweite Verbindungsleitung elektrisch verbunden sind, wobei das zweite Induktivitätsbauelement mit der zweiten Verbindungsleitung und dem zweiten Ausgang elektrisch verbunden ist und die zweite Spannungsabwärtswandlereinheit vorzugsweise dazu eingerichtet ist, die zwei zweiten Schalter der zweiten Tiefsetzstellereinheit gegensinnig zueinander zu schalten. Die in Zusammenhang mit der ersten Tiefsetzstellereinheit beschriebenen Merkmale, Effekte und Funktionsweisen gelten entsprechend auch für die zweite Tiefsetzstellereinheit.

Um hohe Leistungen am Batteriesimulatorausgang zur Verfügung stellen zu können, ist es vorteilhaft, wenn die erste Spannungsabwärtswandlereinheit zumindest zwei parallelgeschaltete erste Tiefsetzstellereinheiten aufweist, die vorzugsweise ident ausgebildet sind. Bevorzugt sind zumindest drei oder zumindest vier parallelgeschaltete erste Tiefsetzstellereinheiten vorgesehen. Bevorzugt ist, wenn die ersten Tiefsetztellereinheiten parallel zu dem ersten Zwischenkreis angeordnet sind. Vorzugsweise werden die ersten Tiefsetzstellereinheiten jeweils mit ersten Schaltmustern aktuiert, die jeweils das gleiche Tastverhältnis aufweisen, aber zueinander zeitversetzte Einschaltzeiten aufweisen. Auf diese werden die ersten Tiefsetzstellereinheiten in jedem Zyklus nacheinander geschaltet.

Auch hinsichtlich der zweiten Spannungsabwärtswandlereinheit kann vorgesehen sein, dass die zweite Spannungsabwärtswandlereinheit zumindest zwei parallelgeschaltete zweite Tiefsetzstellereinheiten aufweist, die vorzugsweise ident ausgebildet sind. Die im Zusammenhang mit der ersten Tiefsetzstellereinheit beschriebenen Merkmale, Effekte und Funktionsweisen gelten vorzugsweise anlog auch für die zweite Tiefsetzstellereinheit.

Um die maximale Betriebsspannung der eingesetzten Schalter nicht zu überschreiten, ist es günstig, wenn im Betrieb des Batteriesimulators die erste und/oder die zweite Zwischenkreisspannung im Bereich zwischen 400 V und 1000 V, vorzugsweise im Bereich zwischen 600 V und 900 V, insbesondere bei im Wesentlichen 800 V, liegt.

Um die Batteriesimulatorausgangsspannung zu stabilisieren, ist es günstig, wenn ein erster Stützkondensator mit dem ersten Spannungsbezugspunkt und dem ersten Ausgang verbunden ist und/oder ein zweiter Stützkondensator mit dem zweiten Spannungsbezugspunkt und dem zweiten Ausgang verbunden ist. Der erste und/oder zweite Stützkondensator kann beispielsweise eine Kapazität zwischen 10 µF und 1000 µF besitzen.

Die Erfindung betrifft auch einen Testaufbau, der folgendes aufweist:
einen Batteriesimulator gemäß der oben beschriebenen Art; und
einen Prüfling, insbesondere eine Antriebseinheit für ein Fahrzeug, welcher an den Batteriesimulatorausgang des Batteriesimulators angeschlossenen ist.
Der Testaufbau kann insbesondere an einem Prüfstand eingesetzt werden. Der Prüfling kann beispielsweise innerhalb eines Fahrzeugs angeordnet sein oder von diesem getrennt an den Batteriesimulator angeschlossen sein.

Des Weiteren betrifft die Erfindung ein Verfahren zum Betreiben eines Batteriesimulators zum Testen eines Prüflings, insbesondere einer elektrischen Antriebseinheit für ein Fahrzeug, wobei der Batteriesimulator gemäß der oben beschriebenen Art ausgebildet ist und das Verfahren folgende Schritte aufweist:
i) Schalten des zumindest einen ersten Schalters gemäß dem zumindest einen ersten Schaltmuster, um die erste Ausgangsspannung zu erzeugen;
ii) Schalten des zumindest einen zweiten Schalters gemäß dem zumindest einen zweiten Schaltmuster, um die zweite Ausgangsspannung zu erzeugen;
iii) Ausgeben der Batteriesimulatorausgangsspannung an dem Batteriesimulatorausgang des Batteriesimulators.

Die Schritte des Verfahrens können gleichzeitig und insbesondere fortwährend während eines Zeitraums, beispielsweise während eines Prüflaufs, ausgeführt werden. Das erste und das zweite Schaltmuster, insbesondere deren Tastverhältnisse, können unabhängig voneinander eingestellt werden, um die Höhe der Batteriesimulatorausgangsspannung zu verändern. Die Batteriesimulatorausgangsspannung kann bei einer Ausführungsform der Erfindung mit einer Steuer- und/oder Regelungseinrichtung gesteuert und/oder geregelt werden. Hinsichtlich einer Regelung ist es günstig, wenn die erste Ausgangsspannung, die zweite Ausgangsspannung und/oder die Batteriesimulatorausgangsspannung mithilfe einer Spannungsmesseinrichtung gemessen und der Steuer- und/oder Regelungseinrichtung zur Verfügung gestellt wird. Bei einer weiteren Ausführungsform der Erfindung wird zusätzlich oder alternativ auch ein erster Ausgangsstrom der ersten Spannungsabwärtswandlereinheit, ein zweiter Ausgangsstrom der zweiten Spannungsabwärtswandlereinheit und/oder ein Batteriesimulatorausgangsstrom am Batteriesimulatorausgang mithilfe einer Strommesseinrichtung gemessen und der Steuer- und/oder Regelungseinrichtung zur Verfügung gestellt.

Die Erfindung betrifft auch ein Verfahren zum Testen eines Prüflings, insbesondere einer Antriebseinheit für ein Fahrzeug, wobei der Prüfling an einem Batteriesimulatorausgang eines Batteriesimulators wie oben beschrieben angeschlossen ist und der Batteriesimulator gemäß dem oben beschriebenen Verfahren zum Betreiben eines Batteriesimulators betrieben wird. Der Batteriesimulator kann an einem Prüfstand eingesetzt werden.

Die Erfindung wird nachfolgend anhand von Figuren beschrieben, auf die sie jedoch nicht beschränkt sein soll. Es zeigen:
Fig. 1 ein Schaltbild eines Batteriesimulators aus dem Stand der Technik;
Fig. 2 eine nicht erfindungsgemäße Verschaltung zweier Spannungsabwärtswandlereinheiten;
Fig. 3 ein Schaltbild eines Batteriesimulators gemäß der Erfindung; und
Fig. 4 ein erstes und ein zweites Schaltmuster.

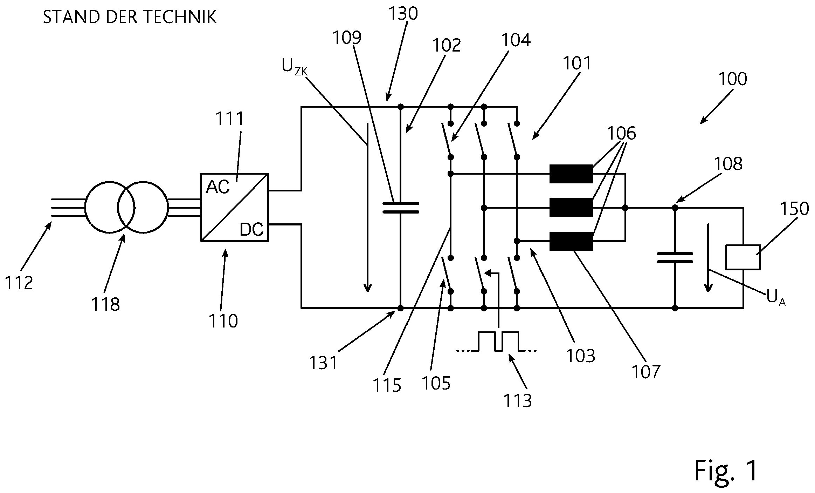

Fig. 1 zeigt ein Schaltbild eines Batteriesimulators 100 zum Testen eines Prüflings 150 gemäß dem Stand der Technik. Bei dem Prüfling 150 kann es sich zum Beispiel um eine elektrische Antriebseinheit für ein Fahrzeug handeln, welche beispielsweise einen Wechselrichter und einen elektrischen Antrieb aufweisen kann. Der dargestellte Batteriesimulator 100 weist eine Spannungsabwärtswandlereinheit 101 auf, die dazu eingerichtet ist, elektrische Spannungen von einem höheren Spannungsniveau auf ein niedrigeres Spannungsniveau zu wandeln. Zu diesem Zweck weist die Spannungsabwärtswandlereinheit 101 einen Zwischenkreis 102 und drei parallelgeschaltete Tiefsetzstellereinheiten 103 auf. Die Tiefsetzstellereinheiten 103 weisen wiederum jeweils zwei über eine Verbindungsleitung 115 miteinander verbundene Schalter 104, 105 und ein Induktivitätsbauelement 106, beispielsweise Drosseln 107, auf. Die Induktivitätsbauelemente 106 sämtlicher parallelgeschalteter Tiefsetzstellereinheiten 103 sind an einem Verschaltungspunkt miteinander verbunden. Der Verschaltungspunkt bildet gleichzeitig den Ausgang 108 des Batteriesimulators 100 bzw. ist mit diesem verbunden. Der Zwischenkreis 102 des Batteriesimulators 100 weist einen Zwischenkreiskondensator 109 auf, der über einen Netzumrichter 110, insbesondere einen Gleichrichter 111, versorgt wird. Der Netzumrichter 110 ist über einen Transformator 118 mit einem dreiphasigen Energieversorgungsnetz 112 verbunden. Um eine Zwischenkreisspannung U_{ZK} auf ein niedrigeres Spannungsniveau am Ausgang 108 des Batteriesimulators zu wandeln, werden die Schalter 104, 105 der Tiefsetzstellereinheiten 103 jeweils gemäß eines schematisch für einen Schalter 105 eingezeichneten Schaltmusters 113 geschaltet, wobei die oberen Schalter 104 jeder Tiefsetzstellereinheit 103 zu den unteren Schaltern 105 der jeweiligen Tiefsetzstellereinheit 103 gegensinnig geschaltet werden, um Kurzschlüsse zu vermeiden. Durch die Verwendung der unteren Schalter 105 anstelle von Dioden, wie sonst bei Tiefsetzstellern im Stand der Technik üblich, wird eine Rückspeisefähigkeit des Batteriesimulators 100 ermöglicht. Mithilfe der Spannungsabwärtswandlereinheit 101 und geeigneten Schaltmustern 113 können Batteriesimulatorausgangsspannungen U_{A} erzeugt werden, die zwischen 0 V und der Zwischenkreisspannung U_{ZK} liegen. Typischerweise beträgt die Zwischenkreisspannung U_{ZK} zwischen 600 V und 1000 V, vorzugsweise im Wesentlichen 800 **V.** Entsprechend liegt die Batteriesimulatorausgangsspannungen U_{A} zwischen 0 V und 1000 V.

Elektrisch angetriebene Fahrzeuge werden mit zunehmend höheren Spannungen von bis zu 1500 V betrieben, sodass auch bei Batteriesimulatoren 100 höhere Batteriesimulatorausgangsspannungen U_{A} gefragt sind. Allerdings kann zur Erzeugung höherer Batteriesimulatorausgangsspannungen U_{A} nicht einfach die Zwischenkreisspannung U_{ZK} erhöht werden, da die maximale Betriebsspannung der Schalter 104, 105 überschritten werden könnte. Die maximale Betriebsspannung vieler für Batteriesimulatoren 100 geeigneter Schalter 104, 105 liegt in etwa bei 1000 V und damit deutlich unterhalb der Sperrspannung der Schalter 104, 105, sodass diese auch bei transienten Spannungsschwankungen nicht überschritten wird. Des Weiteren verlangt die sogenannte Niederspannungsrichtlinie 2014/35/EU vom 26. Februar 2014 eine maximale Potentialdifferenz von 1500 V bei Gleichspannungs- bzw. Gleichstromanwendungen. Auch dadurch sind Spannungserhöhungen und Änderungen im Schaltungsdesign innerhalb von Batteriesimulatoren 100 nur eingeschränkt möglich.

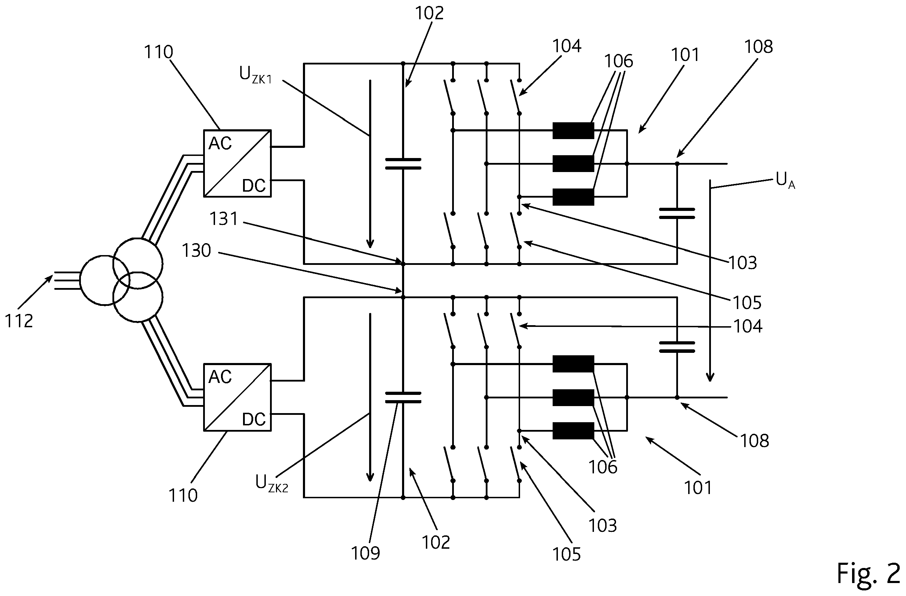

Um allgemein bei Schaltungen mit Spannungsabwärtswandlereinheiten 101 die Ausgangsspannungen der Schaltungen zu erhöhen, ist aus dem Stand der Technik bekannt, mehrere Spannungsabwärtswandlereinheiten 101 in Serie zu schalten, indem jeweils ein Pluspol 130 einer Spannungsabwärtswandlereinheit 101 mit einem Minuspol 131 einer anderen Spannungsabwärtswandlereinheit 101 elektrisch verbunden wird (siehe Fig. 2). Dadurch könnte zwar die Batteriesimulatorausgangsspannung U_{A} eines Batteriesimulators 100 erhöht werden, allerdings treten dabei auch sehr hohe Potentialdifferenzen auf, die bereits bei Verwendung von zwei in Serie geschalteten Spannungsabwärtswandlereinheiten 101 und Zwischenkreisspannungen U_{ZK} von mehr als 750 V die gemäß der Niederspannungsrichtlinie zulässige Höchstgrenze von 1500 V für Gleichspannungs- bzw. Gleichstromanwendungen überschreiten.

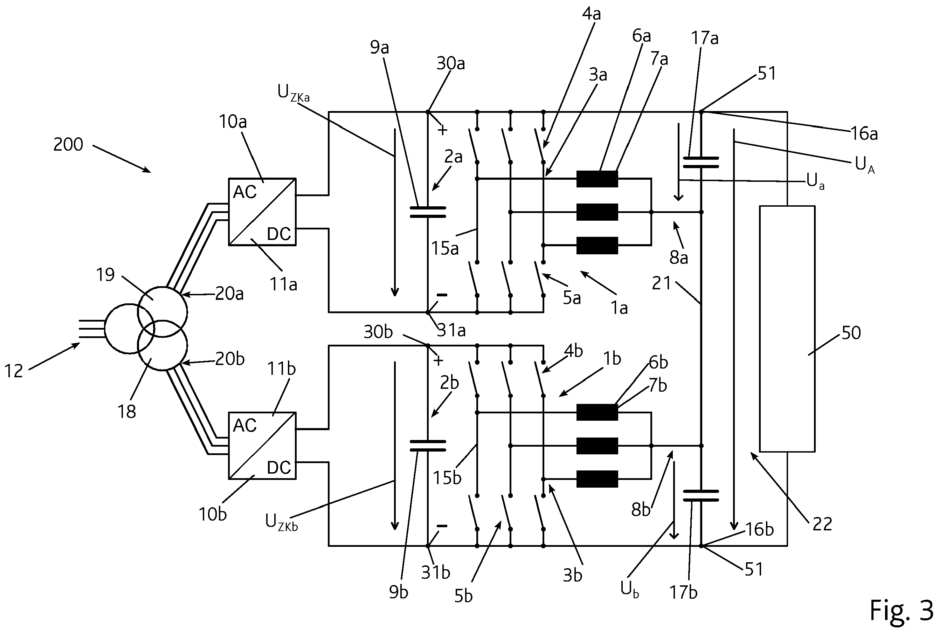

Gemäß der Erfindung ist daher eine andere Verschaltung von Spannungsabwärtswandlereinheiten 101 vorgesehen, welche im Folgenden anhand von Fig. 3 näher beschrieben wird.

Fig. 3 zeigt einen erfindungsgemäßen Batteriesimulator 200 mit einer ersten Spannungsabwärtswandlereinheit 1a und einer zweiten Spannungsabwärtswandlereinheit 1b.

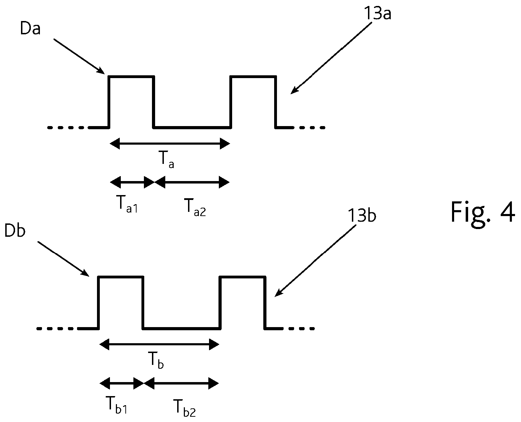

Die erste Spannungsabwärtswandlereinheit 1a weist einen ersten Zwischenkreis 2a, insbesondere einen ersten Spannungszwischenkreis, sowie mehrere parallelgeschaltete erste Tiefsetzstellereinheiten 3a auf. Die ersten Tiefsetzstellereinheiten 3a weisen jeweils zwei über eine erste Verbindungsleitung 15a verbundene erste Schalter 4a, 5a sowie ein erstes Induktivitätsbauelement 6a auf. Als erste Schalter 4a, 5a können beispielsweise IGBT-Schalter oder MOSFET-Schalter, insbesondere SiC-MOSFET-Schalter, eingesetzt werden. Das erste Induktivitätsbauelement 6a kann beispielsweise eine Drossel 7a sein. Die ersten Induktivitätsbauelemente 6a sind jeweils mit den ersten Verbindungsleitungen 15a der entsprechenden Tiefsetzstellereinheiten 3a verbunden. Die ersten Induktivitätsbauelemente 6a sämtlicher erster Tiefsetzstellereinheiten 3a sind weiters an einem ersten Ausgang 8a der ersten Spannungsabwärtswandlereinheit 1a miteinander verbunden. Der erste Zwischenkreis 2a weist einen ersten Zwischenkreiskondensator 9a auf, der über einen ersten Netzumrichter 10a, der beispielsweise als Gleichrichter 11a ausgebildet sein kann, mit elektrischer Energie versorgt wird. Die ersten Tiefsetzstellereinheiten 3a bilden jeweils durch die ersten Schalter 4a, 5a gebildete Halbbrücken aus, welche parallel zu dem ersten Zwischenkreiskondensator 9a angeordnet sind. Um eine erste Zwischenkreisspannung U_{ZKa} des ersten Zwischenkreises 9a auf ein niedrigeres Spannungsniveau zu wandeln, werden die jeweiligen ersten Schalter 4a, 5a der ersten Tiefsetzstellereinheiten 3a gemäß eines ersten Schaltmusters 13a (siehe Fig. 4) angesteuert, wobei die oberen ersten Schalter 4a zu den unteren ersten Schaltern 5a gegensinnig geschaltet werden, um Kurzschlüsse zu vermeiden. Durch die Verwendung der unteren ersten Schalter 5a anstelle von Dioden, wie sonst bei Tiefsetzstellern im Stand der Technik üblich, wird eine Rückspeisefähigkeit des Batteriesimulators 200 ermöglicht. Der erste Zwischenkreis 2a weist einen ersten Pluspol 30a sowie einen ersten Minuspol 31a auf, zwischen denen der erste Zwischenkreiskondensator 9a eingefügt ist. Mithilfe der ersten Spannungsabwärtswandlereinheit 1a und geeigneten ersten Schaltmustern 13a für die ersten Schalter 4a, 5a der ersten Tiefsetzstellereinheiten 3a kann eine erste Ausgangsspannung Uₐ zwischen dem ersten Ausgang 8a und einem ersten Spannungsbezugspunkt 16a erzeugt werden, deren Spannungsniveau zwischen 0 V und der ersten Zwischenkreisspannung U_{ZKa} liegt und einstellbar ist. In der gezeigten Ausführungsform ist der erste Spannungsbezugspunkt 16a direkt mit dem ersten Pluspol 30a der ersten Spannungsabwärtswandlereinheit 1a verbunden und liegt daher im Wesentlichen auf dem Pluspotential + des ersten Zwischenkreises 2a. Zwischen dem ersten Ausgang 8a und dem ersten Spannungsbezugspunkt 16a ist zur Spannungsstabilisation ein erster Stützkondensator 17a angeordnet, sodass die erste Ausgangsspannung Uₐ im Wesentlichen über den ersten Stützkondensator 17a abfällt. Vorzugsweise beträgt die erste Zwischenkreisspannung U_{ZKa} zwischen 600 V und 1000 V, insbesondere im Wesentlichen 800 V. Entsprechend liegt die erste Ausgangsspannung Uₐ zwischen 0 V und 1000 V. Die ersten Tiefsetzstellereinheiten 3a werden jeweils mit ersten Schaltmustern 13a angesteuert, die jeweils das gleiche Tastverhältnis Dₐ aufweisen, aber zueinander zeitversetzte Einschaltzeiten aufweisen. Auf diese werden in jedem Schaltzyklus die ersten Tiefsetzstellereinheiten 3a, insbesondere deren jeweils oberen erste Schalter 4a bzw. deren jeweils unteren erste Schalter 5a, nacheinander geschaltet.

Die zweite Spannungsabwärtswandlereinheit 1b weist einen zweiten Zwischenkreis 2b, insbesondere einen zweiten Spannungszwischenkreis, sowie mehrere parallelgeschaltete zweite Tiefsetzstellereinheiten 3b auf. Die zweiten Tiefsetzstellereinheiten 3b weisen jeweils zwei über eine zweite Verbindungsleitung 15b verbundene zweite Schalter 4b, 5b sowie ein zweites Induktivitätsbauelement 6b auf. Die zweiten Induktivitätsbauelemente 6b sind jeweils mit den zweiten Verbindungsleitungen 15b verbunden. Die zweiten Induktivitätsbauelemente 6b sämtlicher zweiter Tiefsetzstellereinheiten 3b sind weiters an einem zweiten Ausgang 8b der zweiten Spannungsabwärtswandlereinheit 1b miteinander verbunden. Als zweite Schalter 4b, 5b können beispielsweise IGBT-Schalter oder MOSFET-Schalter, insbesondere SiC-MOSFET-Schalter, eingesetzt werden. Das zweite Induktivitätsbauelement 6b kann beispielsweise eine Drossel 7b sein. Der zweite Zwischenkreis 2b weist einen zweiten Zwischenkreiskondensator 9b auf, der über einen zweiten Netzumrichter 10b, der beispielsweise als Gleichrichter 11b ausgebildet ist, mit elektrischer Energie versorgt wird. Die ersten Tiefsetzstellereinheiten 3b bilden jeweils durch die zweiten Schalter 4b, 5b gebildete Halbbrücken aus, welche parallel zu dem zweiten Zwischenkreiskondensator 9b angeordnet sind. Um eine zweite Zwischenkreisspannung U_{ZKb} auf ein niedrigeres Spannungsniveau zu wandeln, werden die jeweiligen zweiten Schalter 4b, 5b der zweiten Tiefsetzstellereinheiten 3b gemäß eines zweiten Schaltmusters 13b (siehe Fig. 4) angesteuert, wobei die oberen zweiten Schalter 4b zu den unteren zweiten Schaltern 5b gegensinnig geschaltet werden, um Kurzschlüsse zu vermeiden. Durch die Verwendung der unteren zweiten Schalter 5b anstelle von Dioden, wie sonst bei Tiefsetzstellern üblich, wird eine Rückspeisefähigkeit des Batteriesimulators 200 ermöglicht. Der zweite Zwischenkreis 2b weist einen zweiten Pluspol 30b sowie einen zweiten Minuspol 31b auf, zwischen denen der zweite Zwischenkreiskondensator 9b eingefügt ist. Mithilfe der zweiten Spannungsabwärtswandlereinheit 1b und geeigneten zweiten Schaltmustern 13b für die zweiten Schalter 4b, 5b der zweiten Tiefsetzstellereinheiten 3b kann eine zweite Ausgangsspannung U_{b} zwischen dem zweiten Ausgang 8b und einem zweiten Spannungsbezugspunkt 16b erzeugt werden, die zwischen 0 V und der zweiten Zwischenkreisspannung U_{ZKb} liegt. In der gezeigten Ausführungsform ist der zweite Spannungsbezugspunkt 16b direkt mit dem zweiten Minuspol 31b der zweiten Spannungsabwärtswandlereinheit 1b verbunden und liegt im Wesentlichen auf dem Minuspotential - des zweiten Zwischenkreises 2b. Zwischen dem zweiten Ausgang 8b und dem zweiten Spannungsbezugspunkt 16b ist zur Spannungsstabilisation ein zweiter Stützkondensator 17b angeordnet, sodass die zweite Ausgangsspannung U_{b} im Wesentlichen über den zweiten Stützkondensator 17b abfällt. Vorzugsweise beträgt die zweite Zwischenkreisspannung U_{ZKb} zwischen 600 V und 1000 V, insbesondere im Wesentlichen 800 V. Entsprechend liegt die zweite Ausgangsspannung U_{b} zwischen 0 V und 1000 V. Die zweiten Tiefsetzstellereinheiten 3b werden jeweils mit zweiten Schaltmustern 13b angesteuert, die jeweils das gleiche Tastverhältnis D₂ aufweisen, aber zueinander zeitversetzte Einschaltzeiten aufweisen. Auf diese werden in jedem Schaltzyklus die zweiten Tiefsetzstellereinheiten 3b, insbesondere deren jeweils oberen zweite Schalter 4b bzw. deren jeweils unteren zweite Schalter 5b, nacheinander geschaltet.

In Fig. 3 ist erkennbar, dass der erste Netzumrichter 10a und der zweite Netzumrichter 10b mit einem Transformator 18 verbunden sind. Der Transformator 18 ist wiederum an ein Energieversorgungsnetz 12 angeschlossen und dazu eingerichtet, elektrische Energie aus dem Energieversorgungsnetz 12 an die Netzumrichter 10a, 10b zu übertragen. In der gezeigten Ausführungsform ist der Transformator 18 ein Trenntransformator 19 mit zwei jeweils dreiphasigen Abgängen 20a, 20b. Durch den Trenntransformator 19 sind die Netzumrichter 10a, 10b galvanisch voneinander getrennt.

Wie in Fig. 3 gezeigt, sind der erste Ausgang 8a der ersten Spannungsabwärtswandlereinheit 1a und der zweite Ausgang 8b der zweiten Spannungsabwärtswandlereinheit 1b über eine elektrische Verbindungsleitung 21 miteinander verbunden. Mit anderen Worten sind der erste 8a und der zweite Ausgang 8b miteinander verschaltet. In der gezeigten Darstellung sind der erste 8a und der zweite Ausgang 8b direkt, d.h. ohne dazwischengeschaltetes elektrisches Bauelement, miteinander verbunden. Die erste 1a und die zweite Spannungsabwärtswandlereinheit 1b sind in Fig. 3 ausschließlich an den Ausgängen 8a, 8b über die Verbindungsleitung 21 elektrisch miteinander verbunden. Im Unterschied zur Schaltung gemäß Fig. 2 sind der Pluspol 30b des zweiten Zwischenkreises 2b und der Minuspol 31a des ersten Zwischenkreises 2a nicht miteinander verbunden, d.h. voneinander getrennt. Über den Trenntransformator 19 sind die Spannungsabwärtswandlereinheiten 1a, 1b galvanisch getrennt und daher allenfalls indirekt über das Energieversorgungsnetz 12 magnetisch, aber nicht elektrisch gekoppelt. Durch die Verbindung der ersten 8a und zweiten Ausgänge 8b kann eine Batteriesimulatorausgangsspannung U_{A} von bis zu 1500 V erzeugt werden, ohne die Zwischenkreisspannungen U_{ZKa}, U_{ZKb} zu erhöhen und ohne die für die Anwendung der Niederspannungsrichtlinie maximal zulässige Potentialdifferenz von 1500 V zu überschreiten. Die Zwischenkreisspannungen U_{ZKa}, U_{ZKb} können beispielsweise zwischen 700 V und 1000 V betragen. Die Batteriesimulatorausgangsspannung U_{A} liegt im Betrieb des Batteriesimulators 200 zwischen dem ersten 16a und dem zweiten Spannungsbezugspunkt 16b an. Der erste 16a und der zweite 16b Spannungsbezugspunkt 16b bilden in der gezeigten Darstellung die Ausgangsklemmen 51 eines Batteriesimulatorausgang 22. Über den Batteriesimulatorausgang 22 ist die Batteriesimulatorausgangsspannung U_{A} abgreifbar. Der Batteriesimulatorausgang 22 kann an einem Gehäuse (nicht gezeigt) des Batteriesimulators 200 angeordnet oder in dieses integriert sein.

Nachfolgend wird die Berechnung der Batteriesimulatorausgangsspannung U_{A} des Batteriesimulators 200 anhand von Fig. 3 und Fig. 4 erläutert. Ein erstes Schaltmuster 13a weist eine Schaltperiode Tₐ auf. Innerhalb der ersten Schaltperiode Tₐ ist der obere erste Schalter 4a für die Zeitdauer Tₐ₁ eingeschaltet, während der untere erste Schalter 5a ausgeschaltet ist. Während der Zeitdauer ${T}_{a 2} = {T}_{a} - {T}_{a 1}$ (1) ist der obere erste Schalter 4a ausgeschaltet, während der untere erste Schalter 5a eingeschaltet ist. Das Verhältnis ${D}_{a} = {T}_{a 1} / {T}_{a}$ (2) wird als erstes Tastverhältnis des ersten Schaltmusters 13a bezeichnet.

Analog wird für das zweite Schaltmuster 13b definiert: ${T}_{b 2} = {T}_{b} - {T}_{b 1}$ (3) ${D}_{b} = {T}_{b 1} / {T}_{b}$ (4)

Die Tastverhältnisse Dₐ, D_{b} sind über die Wahl der Zeitdauern Tₐ₁, Tₐ₂ bzw. T_{b1}, T_{b2} einstellbar. Die Tastverhältnisse Dₐ, D_{b} können zwischen 0 und 1 liegen und sind vorzugsweise unabhängig voneinander einstellbar. Mit Hilfe der Tastverhältnisses Dₐ, D_{b} können die mittlere erste Ausgangsspannung Uₐ und die mittlere zweite Ausgangsspannung U_{b} (für den Fall einer einzigen Tiefsetzstellereinheit 3a, 3b) für den eingeschwungenen Fall berechnet werden. Es gilt: ${U}_{a} = \left(1-{D}_{a}\right) {U}_{ZKa}$ (5) ${U}_{b} = {D}_{b} {U}_{ZKb}$ (6)

Dabei wird das Tastverhältnis Dₐ nicht direkt mit U_{ZKa} multipliziert, sondern der Faktor (1-Dₐ), weil der erste Spannungsbezugspunkt 16a auf dem Pluspotential + des ersten Zwischenkreises 2a liegt.

Werden mehrere Tiefsetzstellereinheiten 3a, 3b eingesetzt, werden diese vorzugsweise zeitversetzt ("interleaved"), aber mit dem gleichen Tastverhältnis Dₐ, D_{b} angesteuert, sodass sich nichts an der Berechnung für den eingeschwungenen Zustand der jeweiligen Tiefsetzstellereinheiten 3a, 3b ändert.

Für die Berechnung der Batteriesimulatorausgangsspannung U_{A} gilt: ${U}_{A} = {U}_{a} + {U}_{b} = \left(1-{D}_{a}\right) {U}_{ZKa} + {D}_{b} {U}_{ZKb}$ (7)

## Patentansprüche

1. Batteriesimulator (200) zum Testen eines Prüflings (50), insbesondere einer elektrischen Antriebseinheit für ein Fahrzeug, aufweisend:
eine erste Spannungsabwärtswandlereinheit (1a) mit
- zumindest einem ersten Schalter (4a, 5a),
- einem ersten Zwischenkreis (2a),
- einem ersten Ausgang (8a) und
- einem ersten Spannungsbezugspunkt (16a),
wobei die erste Spannungsabwärtswandlereinheit (1a) dazu eingerichtet ist, den zumindest einen ersten Schalter (4a, 4b) gemäß zumindest eines ersten Schaltmusters (13a) zu schalten und dadurch eine erste Zwischenkreisspannung (U_{ZKa}) des ersten Zwischenkreises (2a) in eine erste Ausgangsspannung (Uₐ) zu wandeln, welche im Betrieb des Batteriesimulators (200) zwischen dem ersten Spannungsbezugspunkt (16a) und dem ersten Ausgang (8a) anliegt,
**gekennzeichnet durch**
eine zweite Spannungsabwärtswandlereinheit (1b) mit
- zumindest einem zweiten Schalter (4b, 5b),
- einem zweiten Zwischenkreis (2b),
- einem zweiten Ausgang (8b) und
- einem zweiten Spannungsbezugspunkt (16b),
wobei die zweite Spannungsabwärtswandlereinheit (1b) dazu eingerichtet ist, den zumindest einen zweiten Schalter (4b, 5b) gemäß zumindest eines zweiten Schaltmusters (13b) zu schalten und dadurch eine zweite Zwischenkreisspannung (U_{ZKb}) des zweiten Zwischenkreises (2b) in eine zweite Ausgangsspannung (U_{b}) zu wandeln, welche im Betrieb des Batteriesimulators (200) zwischen dem zweiten Spannungsbezugspunkt (16b) und dem zweiten Ausgang (8b) anliegt,
wobei der erste Ausgang (8a) und der zweite Ausgang (8b) elektrisch miteinander verbunden sind und ein elektrischer Batteriesimulatorausgang (22) mit dem ersten (16a) und dem zweiten Spannungsbezugspunkt (16b) verbunden ist, sodass im Betrieb des Batteriesimulators (200) eine Batteriesimulatorausgangsspannung (U_{A}) zwischen dem ersten (16a) und dem zweiten Spannungsbezugspunkt (16b) anliegt und an dem Batteriesimulatorausgang (22) abgreifbar ist.

2. Batteriesimulator (200) nach Anspruch 1, **dadurch gekennzeichnet, dass** der erste Spannungsbezugspunkt (16a) mit einem Pluspol (30a) der ersten Spannungsabwärtswandlereinheit (1a) verbunden ist und vorzugsweise im Wesentlichen ein Pluspotential (+) des ersten Zwischenkreises (2a) besitzt, und/oder der zweite Spannungsbezugspunkt (16b) mit einem Minuspol (31b) der zweiten Spannungsabwärtswandlereinheit (1b) verbunden ist und vorzugsweise im Wesentlichen ein Minuspotential (-) des zweiten Zwischenkreises (2b) besitzt.

3. Batteriesimulator (200) nach Anspruch 1 oder 2, **dadurch gekennzeichnet, dass** die erste (1a) und die zweite Spannungsabwärtswandlereinheit (1b) ausschließlich über den ersten (8a) und den zweiten Ausgang (8b) elektrisch miteinander verbunden sind.

4. Batteriesimulator (200) nach einem der Ansprüche 1 bis 3, **dadurch gekennzeichnet, dass** die erste (1a) und die zweite Spannungsabwärtswandlereinheit (1b) im Wesentlichen ident ausgebildet sind.

5. Batteriesimulator (200) nach einem der Ansprüche 1 bis 4, **dadurch gekennzeichnet, dass** der Batteriesimulator (200) einen ersten Netzumrichter (10a), insbesondere einen ersten Gleichrichter (11a), und einen zweiten Netzumrichter (10b), insbesondere einen zweiten Gleichrichter (11b), aufweist, wobei der erste Netzumrichter (10a) mit dem ersten Zwischenkreis (2a) und der zweite Netzumrichter (10b) mit dem zweiten Zwischenkreis (2b) verbunden ist.

6. Batteriesimulator (200) nach Anspruch 5, **dadurch gekennzeichnet, dass** der erste (10a) Netzumrichter und der zweite Netzumrichter (10b) galvanisch voneinander getrennt sind.

7. Batteriesimulator (200) nach Anspruch 5 oder 6, **dadurch gekennzeichnet, dass** der Batteriesimulator (200) zumindest einen Transformator (18) aufweist, der dazu eingerichtet ist, den ersten (10a) und/oder den zweiten Netzumrichter (10b) zu speisen.

8. Batteriesimulator (200) nach einem der Ansprüche 1 bis 7, **dadurch gekennzeichnet, dass** die erste Spannungsabwärtswandlereinheit (1a) zumindest eine erste Tiefsetzstellereinheit (3a) aufweist, welche zumindest einen ersten Schalter (4a, 5a) und ein erstes Induktivitätsbauelement (6a) aufweist.

9. Batteriesimulator (200) nach Anspruch 8, **dadurch gekennzeichnet, dass** die zumindest eine erste Tiefsetzstellereinheit (3a) zwei erste Schalter (4a, 5a) aufweist, die über eine erste Verbindungsleitung (15a) elektrisch verbunden sind, wobei das erste Induktivitätsbauelement (6a) mit der ersten Verbindungsleitung (15a) und dem ersten Ausgang (8a) elektrisch verbunden ist und die erste Spannungsabwärtswandlereinheit (1a) vorzugsweise dazu eingerichtet ist, die zwei ersten Schalter (4a, 5a) der ersten Tiefsetzstellereinheit (3a) gegensinnig zueinander zu schalten.

10. Batteriesimulator (200) nach einem der Ansprüche 8 oder 9, **dadurch gekennzeichnet, dass** die erste Spannungsabwärtswandlereinheit (1a) zumindest zwei parallelgeschaltete erste Tiefsetzstellereinheiten (3a) aufweist, die vorzugsweise ident ausgebildet sind.

11. Batteriesimulator (200) nach einem der Ansprüche 1 bis 10, dadurch dass im Betrieb des Batteriesimulators (200) die erste (U_{ZKa}) und/oder die zweite Zwischenkreisspannung (U_{ZKb}) im Bereich zwischen 400 V und 1000 V, vorzugsweise im Bereich zwischen 600 V und 900 V, insbesondere bei im Wesentlichen 800 V, liegt.

12. Batteriesimulator (200) nach einem der Ansprüche 1 bis 11, **dadurch gekennzeichnet, dass** ein erster Stützkondensator (17a) mit dem ersten Spannungsbezugspunkt (16a) und dem ersten Ausgang (8a) verbunden ist und/oder ein zweiter Stützkondensator (17b) mit dem zweiten Spannungsbezugspunkt (16b) und dem zweiten Ausgang (8b) verbunden ist.

13. Testaufbau, aufweisend:
einen Batteriesimulator (200) nach einem der Ansprüche 1 bis 12; und
einen Prüfling (50), insbesondere eine Antriebseinheit für ein Fahrzeug, welcher an den Batteriesimulatorausgang (22) des Batteriesimulators (200) angeschlossenen ist.

14. Verfahren zum Betreiben eines Batteriesimulators (200) zum Testen eines Prüflings (50), insbesondere einer elektrischen Antriebseinheit für ein Fahrzeug, wobei der Batteriesimulator (200) gemäß einem der Ansprüche 1 bis 12 ausgebildet ist und das Verfahren folgende Schritte aufweist:
i) Schalten des zumindest einen ersten Schalters (4a, 5a) gemäß dem zumindest einen ersten Schaltmuster (13a), um die erste Ausgangsspannung (Uₐ) zu erzeugen;
ii) Schalten des zumindest einen zweiten Schalters (4b, 5b) gemäß dem zumindest einen zweiten Schaltmuster (13b), um die zweite Ausgangsspannung (U_{b}) zu erzeugen;
iii) Ausgeben der Batteriesimulatorausgangsspannung (U_{A}) an dem Batteriesimulatorausgang (22) des Batteriesimulators (200).

15. Verfahren zum Testen eines Prüflings (50), insbesondere einer Antriebseinheit für ein Fahrzeug, wobei der Prüfling an einem Batteriesimulatorausgang (22) eines Batteriesimulators (200) gemäß einem der Ansprüche 1 bis 12 angeschlossen ist und der Batteriesimulator (200) gemäß dem Verfahren nach Anspruch 14 betrieben wird.

## Claims

1. A battery simulator (200) for testing an object under test (50), in particular an electric drive unit for a vehicle, comprising:
a first voltage decreasing unit (1a) comprising
- at least one first switch (4a, 5a),
- a first intermediate circuit (2a),
- a first output (8a) and
- a first voltage reference point (16a),
wherein the first voltage decreasing unit (1a) is configured to switch the at least one first switch (4a, 4b) according to at least one first switching pattern (13a) and thereby convert a first intermediate circuit voltage (U_{ZKa}) of the first intermediate circuit (2a) into a first output voltage (Uₐ) which is applied between the first voltage reference point (16a) and the first output (8a) during operation of the battery simulator (200),
**characterized by**
a second voltage decreasing unit (1b) comprising
- at least one second switch (4b, 5b),
- a second intermediate circuit (2b),
- a second output (8b) and
- a second voltage reference point (16b),
wherein the second voltage decreasing unit (1b) is configured to switch the at least one second switch (4b, 5b) according to at least one second switching pattern (13b) and thereby convert a second intermediate circuit voltage (U_{ZKb}) of the second intermediate circuit (2b) into a second output voltage (U_{b}) which is applied between the second voltage reference point (16b) and the second output (8b) during operation of the battery simulator (200),
wherein the first output (8a) and the second output (8b) are electrically connected to one another, and an electrical battery simulator output (22) is connected to the first voltage reference point (16a) and the second voltage reference point (16b), such that a battery simulator output voltage (U_{A}) is applied between the first voltage reference point (16a) and the second voltage reference point (16b) during operation of the battery simulator (200) and can be tapped at the battery simulator output (22).

2. The battery simulator (200) according to claim 1, **characterized in that** the first voltage reference point (16a) is connected to a positive pole (30a) of the first voltage decreasing unit (1a) and preferably has essentially a positive potential (+) of the first intermediate circuit (2a), and/or the second voltage reference point (16b) is connected to a negative pole (31b) of the second voltage decreasing unit (1b) and preferably has essentially a negative potential (-) of the second intermediate circuit (2b).

3. The battery simulator (200) according to claim 1 or 2, **characterized in that** the first voltage decreasing unit (1a) and the second voltage decreasing unit (1b) are electrically connected to one another exclusively via the first output (8a) and the second output (8b).

4. The battery simulator (200) according to any one of claims 1 to 3, **characterized in that** the first voltage decreasing unit (1a) and the second voltage decreasing unit (1b) are designed essentially identically.

5. The battery simulator (200) according to any one of claims 1 to 4, **characterized in that** the battery simulator (200) has a first grid converter (10a), in particular a first rectifier (11a), and a second grid converter (10b), in particular a second rectifier (11b), the first grid converter (10a) being connected to the first intermediate circuit (2a) and the second grid converter (10b) being connected to the second intermediate circuit (2b).

6. The battery simulator (200) according to claim 5, **characterized in that** the first grid converter (10a) and the second grid converter (10b) are galvanically isolated from one another.

7. The battery simulator (200) according to claim 5 or 6, **characterized in that** the battery simulator (200) comprises at least one transformer (18), the transformer (18) being configured to feed the first grid converter (10a) and/or the second grid converter (10b).

8. The battery simulator (200) according to any one of claims 1 to 7, **characterized in that** the first voltage decreasing unit (1a) comprises at least one first step-down converter unit (3a), which comprises at least one first switch (4a, 5a) and a first inductance component (6a).

9. The battery simulator (200) according to claim 8, **characterized in that** the at least one first step-down converter unit (3a) comprises two first switches (4a, 5a), the two first switches (4a, 5a) being electrically connected via a first connecting line (15a), wherein the first inductance component (6a) is electrically connected to the first connecting line (15a) and the first output (8a), and the first voltage decreasing unit (1a) is preferably configured to switch the two first switches (4a, 5a) of the first step-down converter unit (3a) in opposite operation to one another.

10. The battery simulator (200) according to any one of claims 8 or 9, **characterized in that** the first voltage decreasing unit (1a) comprises at least two parallel-connected first step-down converter units (3a), the first step-down converter units (3a) preferably being designed identically.

11. The battery simulator (200) according to any one of claims 1 to 10, **characterized in that**, during operation of the battery simulator (200), the first intermediate circuit voltage (U_{ZKa}) and/or the second intermediate circuit voltage (U_{ZKb}) is in the range between 400 V and 1000 V, preferably in the range between 600 V and 900 V, in particular at essentially 800 V.

12. The battery simulator (200) according to any one of claims 1 to 11, **characterized in that** a first stabilizing capacitor (17a) is connected to the first voltage reference point (16a) and the first output (8a) and/or a second stabilizing capacitor (17b) is connected to the second voltage reference point (16b) and the second output (8b).

13. A test setup, comprising:
a battery simulator (200) according to any one of claims 1 to 12; and
an object under test (50), in particular a drive unit for a vehicle, the object under test (5) being connected to the battery simulator output (22) of the battery simulator (200).

14. A method for operating a battery simulator (200) for testing an object under test (50), in particular an electric drive unit for a vehicle, wherein the battery simulator (200) is designed according to one of claims 1 to 12 and the method comprises the following steps:
i) switching the at least one first switch (4a, 5a) according to the at least one first switching pattern (13a) to generate the first output voltage (Uₐ);
ii) switching the at least one second switch (4b, 5b) according to the at least one second switching pattern (13b) to generate the second output voltage (U_{b});
iii) outputting the battery simulator output voltage (U_{A}) at the battery simulator output (22) of the battery simulator (200).

15. A method for testing an object under test (50), in particular a drive unit for a vehicle, wherein the object under test is connected to a battery simulator output (22) of a battery simulator (200) according to any one of claims 1 to 12, and the battery simulator (200) is operated according to the method according to claim 14.

## Revendications

1. Simulateur de batterie (200) pour tester un objet à tester (50), en particulier une unité d'entraînement électrique pour un véhicule, comprenant :
une première unité de convertisseur abaisseur de tension (1a) avec
- au moins un premier commutateur (4a, 5a),
- un premier circuit intermédiaire (2a),
- une première sortie (8a) et
- un premier point de référence de tension (16a),
dans lequel la première unité de convertisseur abaisseur de tension (1a) est configurée pour commuter l'au moins un premier commutateur (4a, 5a) selon au moins un premier motif de commutation (13a) et convertir ainsi une première tension de circuit intermédiaire (U_{ZKa}) du premier circuit intermédiaire (2a) en une première tension de sortie (Uₐ), laquelle est appliquée, lors du fonctionnement du simulateur de batterie (200), entre le premier point de référence de tension (16a) et la première sortie (8a), **caractérisé par**
une deuxième unité de convertisseur abaisseur de tension (1b) avec
- au moins un deuxième commutateur (4b, 5b),
- un deuxième circuit intermédiaire (2b),
- une deuxième sortie (8b) et
- un deuxième point de référence de tension (16b),
dans lequel la deuxième unité de convertisseur abaisseur de tension (1b) est configurée pour commuter l'au moins un deuxième commutateur (4b, 5b) selon au moins un deuxième motif de commutation (13b) et convertir ainsi une deuxième tension de circuit intermédiaire (U_{zKb}) du deuxième circuit intermédiaire (2b) en une deuxième tension de sortie (U_{b}), laquelle est appliquée, lors du fonctionnement du simulateur de batterie (200), entre le deuxième point de référence de tension (16b) et la deuxième sortie (8b),
dans lequel la première sortie (8a) et la deuxième sortie (8b) sont reliées électriquement entre elles et une sortie électrique de simulateur de batterie (22) est reliée au premier (16a) et au deuxième point de référence de tension (16b), de sorte que, lors du fonctionnement du simulateur de batterie (200), une tension de sortie de simulateur de batterie (UA) est appliquée entre le premier (16a) et le deuxième point de référence de tension (16b) et peut être prélevée au niveau de la sortie de simulateur de batterie (22).

2. Simulateur de batterie (200) selon la revendication 1, **caractérisé en ce que** le premier point de référence de tension (16a) est relié à un pôle positif (30a) de la première unité de convertisseur abaisseur de tension (1a) et présente de préférence sensiblement un potentiel positif (+) du premier circuit intermédiaire (2a), et/ou le deuxième point de référence de tension (16b) est relié à un pôle négatif (31b) de la deuxième unité de convertisseur abaisseur de tension (1b) et présente de préférence sensiblement un potentiel négatif (-) du deuxième circuit intermédiaire (2b).

3. Simulateur de batterie (200) selon la revendication 1 ou 2, **caractérisé en ce que** la première (1a) et la deuxième unité de convertisseur abaisseur de tension (1b) sont reliées électriquement entre elles exclusivement par l'intermédiaire de la première (8a) et de la deuxième sortie (8b).

4. Simulateur de batterie (200) selon l'une quelconque des revendications 1 à 3, **caractérisé en ce que** la première (1a) et la deuxième unité de convertisseur abaisseur de tension (1b) sont de réalisation sensiblement identique.

5. Simulateur de batterie (200) selon l'une quelconque des revendications 1 à 4, **caractérisé en ce que** le simulateur de batterie (200) comprend un premier convertisseur de réseau (10a), en particulier un premier redresseur (11a), et un deuxième convertisseur de réseau (10b), en particulier un deuxième redresseur (11b), dans lequel le premier convertisseur de réseau (10a) est relié au premier circuit intermédiaire (2a) et le deuxième convertisseur de réseau (10b) est relié au deuxième circuit intermédiaire (2b).

6. Simulateur de batterie (200) selon la revendication 5, **caractérisé en ce que** le premier convertisseur de réseau (10a) et le deuxième convertisseur de réseau (10b) sont séparés galvaniquement l'un de l'autre.

7. Simulateur de batterie (200) selon la revendication 5 ou 6, **caractérisé en ce que** le simulateur de batterie (200) comprend au moins un transformateur (18) qui est configuré pour alimenter le premier (10a) et/ou le deuxième convertisseur de réseau (10b).

8. Simulateur de batterie (200) selon l'une quelconque des revendications 1 à 7, **caractérisé en ce que** la première unité de convertisseur abaisseur de tension (1a) comprend au moins une première unité de hacheur abaisseur (3a) qui comprend au moins un premier commutateur (4a, 5a) et un premier composant inductif (6a).

9. Simulateur de batterie (200) selon la revendication 8, **caractérisé en ce que** l'au moins une première unité de hacheur abaisseur (3a) comprend deux premiers commutateurs (4a, 5a) qui sont reliés électriquement par l'intermédiaire d'une première ligne de liaison (15a), dans lequel le premier composant inductif (6a) est relié électriquement à la première ligne de liaison (15a) et à la première sortie (8a), et la première unité de convertisseur abaisseur de tension (1a) est de préférence configurée pour commuter les deux premiers commutateurs (4a, 5a) de la première unité de hacheur abaisseur (3a) en sens opposé l'un par rapport à l'autre.

10. Simulateur de batterie (200) selon l'une quelconque des revendications 8 ou 9, **caractérisé en ce que** la première unité de convertisseur abaisseur de tension (1a) comprend au moins deux premières unités de hacheur abaisseur (3a) connectées en parallèle, lesquelles sont de préférence de réalisation identique.

11. Simulateur de batterie (200) selon l'une quelconque des revendications 1 à 10, **caractérisé en ce que**, lors du fonctionnement du simulateur de batterie (200), la première (U_{ZKa}) et/ou la deuxième tension de circuit intermédiaire (U_{ZKb}) se situe dans la plage entre 400 V et 1000 V, de préférence dans la plage entre 600 V et 900 V, en particulier à sensiblement 800 V.

12. Simulateur de batterie (200) selon l'une quelconque des revendications 1 à 11, **caractérisé en ce qu'**un premier condensateur de soutien (17a) est relié au premier point de référence de tension (16a) et à la première sortie (8a) et/ou un deuxième condensateur de soutien (17b) est relié au deuxième point de référence de tension (16b) et à la deuxième sortie (8b).

13. Montage de test, comprenant :
un simulateur de batterie (200) selon l'une quelconque des revendications 1 à 12 ; et
un objet à tester (50), en particulier une unité d'entraînement pour un véhicule, qui est raccordé à la sortie de simulateur de batterie (22) du simulateur de batterie (200).

14. Procédé de fonctionnement d'un simulateur de batterie (200) pour tester un objet à tester (50), en particulier une unité d'entraînement électrique pour un véhicule, dans lequel le simulateur de batterie (200) est réalisé selon l'une quelconque des revendications 1 à 12 et le procédé comprend les étapes suivantes :
i) commutation de l'au moins un premier commutateur (4a, 5a) selon l'au moins un premier motif de commutation (13a) pour générer la première tension de sortie (Ua) ;
ii) commutation de l'au moins un deuxième commutateur (4b, 5b) selon l'au moins un deuxième motif de commutation (13b) pour générer la deuxième tension de sortie (Ub) ;
iii) émission de la tension de sortie de simulateur de batterie (UA) au niveau de la sortie de simulateur de batterie (22) du simulateur de batterie (200).

15. Procédé pour tester un objet à tester (50), en particulier une unité d'entraînement pour un véhicule, dans lequel l'objet à tester est raccordé à une sortie de simulateur de batterie (22) d'un simulateur de batterie (200) selon l'une quelconque des revendications 1 à 12 et le simulateur de batterie (200) fonctionne conformément au procédé selon la revendication 14.
